# EUROPÄISCHE PATENTSCHRIFT

(11) **EP 2 485 827 B1**
(45) Veröffentlichungstag und Bekanntmachung des Hinweises auf die Patenterteilung: **25.01.2017**
(21) Anmeldenummer: 10793144.6
(22) Anmeldetag: 06.10.2010
(51) Int. Cl.: B01D 61/16, B01D 61/14, B24B 37/04, B24B 57/02, C02F 1/44, H01L 21/321

(54) **WIEDERAUFBEREITUNGSVERFAHREN UND WIEDERAUFBEREITUNGSVORRICHTUNG ZUR WIEDERAUFBEREITUNG VON SLURRY-ABWASSER AUS EINEM HALBLEITERBEARBEITUNGSPROZESS, INSBESONDERE AUS EINEM CHEMISCH-MECHANISCHEN POLIERPROZESS**
RECYCLING METHOD AND DEVICE FOR RECYCLING WASTE WATER CONTAINING SLURRY FROM A SEMI-CONDUCTOR TREATMENT PROCESS, IN PARTICULAR FROM A CHEMICO-MECHANICAL POLISHING PROCESS
PROCÉDÉ ET DISPOSITIF DE RETRAITEMENT D'EAUX USÉES CONTENANT DE LA BOUE PROVENANT D'UN PROCESSUS DE TRAITEMENT DE SEMI-CONDUCTEURS, EN PARTICULIER PROVENANT D'UN PROCESSUS DE POLISSAGE CHIMICO-MÉCANIQUE

(30) Priorität: 08.10.2009 DE 102009044204
(43) Veröffentlichungstag der Anmeldung: 15.08.2012
(73) Patentinhaber: HighQ-Factory GmbH, 63863 Eschau-Hobbach (DE)
(72) Erfinder: BRUMMER, Franz, 84034 Landshut (DE)
(74) Vertreter: Michalski Hüttermann & Partner Patentanwälte mbB
(86) Internationale Anmeldenummer: PCT/DE2010/075106
(87) Internationale Veröffentlichungsnummer: WO 2011/042017

(56) Entgegenhaltungen:
- EP-A2- 1 741 674
- WO-A1-99/56189
- JP-A- 2008 034 827
- US-A- 5 647 989
- US-A- 6 077 437
- US-A1- 2002 168 926
- N L RICKER: 'The interlinear literal translation of the Greek New Testament : with the Authorized version conveniently presented in the margins for ready reference and with the various readings of the editions of Elzevir 1624, Griesbach, Lachmann, Tischendorf, Tregelles, Alford and Wordsworth : to which has been', [Online] 01 Januar 1897, UNITED STATES, XP055174547 Gefunden im Internet: <URL:http://catalog.hathitrust.org/Record/0 09795335>
- KOVACS Z ET AL: "Modeling of batch and semi-batch membrane filtration processes", JOURNAL OF MEMBRANE SCIENCE, ELSEVIER, vol. 327, no. 1-2, 5 February 2009 (2009-02-05), pages 164-173, XP025917510, ISSN: 0376-7388, DOI: 10.1016/J.MEMSCI.2008.11.024 [retrieved on 2008-11-21]

## Beschreibung

Die Erfindung betrifft ein Wiederaufbereitungsverfahren und eine Wiederaufbereitungsvorrichtung zur Wiederaufbereitung von Slurry-Abwasser aus einem Halbleiterbearbeitungsprozess, insbesondere aus einem chemisch-mechanischen Polierprozess.

Zum Polieren von Halbleitermaterialien hat sich in den vergangenen Jahren das chemisch-mechanische Polieren (CMP) als Standardverfahren etabliert. Insbesondere wird das CMP nach dem Abscheiden funktioneller Schichten auf Halbleiterwafer angewendet, um beim Abscheiden entstandene Unebenheiten auszugleichen. Hierbei wird ein chemisch und mechanisch aktives, kolloidales Poliermittel, die sogenannte Slurry, zwischen dem Halbleiterwafer und einer Polieroberfläche verteilt. Unterstützt durch Relativbewegungen zwischen Halbleiterwafer und Polieroberfläche wird die Halbleiterwaferoberfläche chemisch angegriffen und poliert.

Der Polieroberfläche muss bei derartigen Polierprozessen fortlaufend frischer Slurry zugeführt werden, um eine optimale Polierleistung zu erzielen. Bei dem Polierprozess entsteht Abwasser, welches neben Polierflüssigkeit (in der Regel Wasser und Slurry) Verunreinigungen enthält, die durch den Polierabtrag entstehen. Zudem enthält das Abwasser in der Regel zusätzliche Chemikalien, die den Polierprozess steuern. Diese können je nach Prozesstyp pH-Regulatoren, Oxidiermittel und / oder Stabilisiermittel umfassen. Das Slurry-Abwasser wird in der Regel abgeführt und entsorgt. Da sowohl die Slurry als auch die Polierflüssigkeit in ihrer Anschaffung kostenintensiv sind, bieten Slurry-Wiederaufbereitungsprozesse ein großes Kosteneinsparungspotential. Bei bekannten Verfahren zur Wiedergewinnung von Slurry aus dem Slurry-Abwasser, wird das aus einer CMP-Vorrichtung abgeführte Abwasser aufgefangen und mittels Misch- und / oder Filterprozessen wiederaufbereitet. Ein derartiges Verfahren wird beispielsweise in EP 0 822 033 A1 offenbart. Bei diesem bekannten Verfahren wird das Abwasser aus dem Polierprozess mittels einer Pumpe abgesaugt und in eine Art Mischvorrichtung geleitet, worin auch weitere Behandlungsstoffe sowie frische Slurry über Rohrleitungen eingeleitet werden. Die daraus resultierende, behandelte Mischung wird als aufbereiteter Slurry über einen Wärmetauscher, mehrere Sensoren sowie schließlich ein Filter geleitet und dem Polierprozess als frische Slurry zugeführt. Derartige lineare Wiederaufbereitungsverfahren, bei denen das Abwasser nach mehreren zeitlich aufeinanderfolgenden Verfahrensschritten dem Polierprozess wieder zugeführt wird, haben den Nachteil, dass an die einzelnen Komponenten der Wiederaufbereitungsvorrichtung sehr hohe Anforderungen zu stellen sind, die sich meist nicht erfüllen lassen.

Im Gegensatz dazu offenbart US 6 722 958 B2 die Wiederaufbereitung von Slurry in einem Kreislaufverfahren. Hiernach wird Abwasser aus einem CMP-Prozess in einen Behälter gefüllt und von dort aus durch ein Ultrafilter geleitet. Hierbei aus dem Abwasser herausgefiltertes Wasser wird entsorgt. Das beim Filtern entstehende Filterprodukt wird als konzentrierte Slurry zurück in den Behälter geleitet. Anschließend oder gleichzeitig wird ein Reinigungsprozess durchgeführt, bei dem regelmäßig Reinigungswasser in den Behälter eingeleitet wird, um die konzentrierte Slurry zu verdünnen und zu waschen, um so Verunreinigungen wie Salze und organische Substanzen herauszulösen. Dieses Verfahren ist jedoch aufwendig und erfüllt zudem nicht das Ziel, auf effizientem Wege eine hohe Konzentration an wiederaufbereiteter Slurry zu erhalten.

Es ist daher Aufgabe der Erfindung, ein Wiederaufbereitungsverfahren und eine Wiederaufbereitungsvorrichtung für eine kosten- und zeiteffiziente Wiederaufbereitung von Slurry und / oder weiteren Fluiden wie beispielsweise Wasser aus Slurry-Abwasser bereitzustellen.

Die Aufgabe wird gemäß der Erfindung durch ein Wiederaufbereitungsverfahren mit den Merkmalen des Anspruchs 1 sowie durch eine Wiederaufbereitungsvorrichtung mit den Merkmalen des Anspruchs 11 gelöst. Vorteilhafte Weiterbildungen der Erfindung sind in den Unteransprüchen aufgeführt.

Die Erfindung beruht zunächst auf dem Prinzip, das wieder aufzubereitende Slurry enthaltende Abwasser in einem Kreislauf mittels Flüssigkeitsentzug aufzukonzentrieren. Hierzu wird das Abwasser zunächst in einen Kreislaufbehälter geleitet. Dort mischt es sich mit im Kreislauf erzeugtem aufkonzentriertem Abwasser zu Mischabwasser. In dem Kreislaufprozess wird Mischabwasser aus dem Kreislaufbehälter entnommen, durch eine Ultrafiltervorrichtung geleitet und hierbei entstehendes aufkonzentriertes Abwasser zurück in den Kreislaufbehälter geleitet.

Die Ultrafiltervorrichtung weist somit zumindest einen Eingang, durch den das aus dem Kreislaufbehälter entnommene Mischabwasser in die Ultrafiltervorrichtung eingeleitet wird, und zumindest zwei Ausgänge auf. In der Ultrafiltervorrichtung wird dem eingeleiteten Mischabwasser Flüssigkeit entzogen, um so ein Aufkonzentrieren des Abwassers zu erreichen. Das aufkonzentrierte Abwasser wird dann durch einen der Ausgänge der Ultrafiltervorrichtung und über eine Abwasserrückführleitung in den Kreislaufbehälter geleitet. Die dem Mischabwasser entzogene Flüssigkeit wird über einen zweiten Ausgang der Ultrafiltervorrichtung ausgestoßen und kann dann vorzugsweise eingesammelt und weiterverwendet werden.

Das Wiederaufbereitungsverfahren umfasst hierbei im Wesentlichen zwei Verfahrensphasen, nämlich eine erste Phase, in welcher der Filtrationsschritt durchgeführt wird, und eine zweite Phase, in welcher der Konzentrationsschritt durchgeführt wird. Bei dem Filtrationsschritt wird, während das Abwasser in dem Kreislauf zwischen dem Kreislaufbehälter und der Ultrafiltervorrichtung aufkonzentriert wird, frisches Slurry-Abwasser in den Kreislaufbehälter geleitet, welches sich mit dem aufkonzentrierten Abwasser mischt.

Demgegenüber zeichnet sich der Konzentrationsschritt dadurch aus, dass während des Aufkonzentrierens des Abwassers in dem Kreislauf die Zufuhr von frischem Slurry-Abwasser in den Kreislaufbehälter vermindert oder im Wesentlichen abgestellt ist. Ein Umschalten zwischen der ersten Phase und der zweiten Phase erfolgt mit Hilfe einer Steuervorrichtung der Wiederaufbereitungsvorrichtung. Der Umschaltvorgang kann beispielsweise zeitlich gesteuert beziehungsweise getriggert sein. Vorzugsweise wird er jedoch aufgrund von Messwerten, welche mittels in der Wiederaufbereitungsvorrichtung angeordneten Sensoren ermittelt werden, und deren Vergleich mit Sollwerten gesteuert.

Der Begriff "frisches Abwasser" verdeutlicht, dass es sich hierbei um Abwasser handelt, welches durch das Einleiten in den Kreislaufbehälter des vorangehend erläuterten Kreislaufs zum Aufkonzentrieren des Abwassers eingeführt wird. Dieses frische Abwasser unterscheidet sich somit von dem aufkonzentriertem Abwasser, welches vom Ausgang der Ultrafiltervorrichtung zum Kreislaufbehälter geleitet wird. Bei dem frischen Abwasser handelt es sich um das Slurry enthaltende Abwasser, welches bei der Halbleiterbearbeitung angefallen ist, beispielsweise beim chemisch-mechanischen Polier-Verfahren (CMP-Verfahren), und durch Abtrag und anderen Chemikalien verunreinigte Slurry umfasst.

Bei dem frischen Abwasser kann es sich auch um vorgefiltertes Abwasser handeln, welches beispielsweise zunächst in einem Vorlagetank aufbewahrt und von dort über einen oder mehreren Vorfilterstufen zum Kreislaufbehälter geleitet wird. Vorzugsweise erfolgt eine Vorfiltration zweistufig und in sehr kleinen Rückhalteraten derart, dass partikuläre Verschmutzungen, beispielsweise aufgrund von Pad-Abrieb in einem CMP-Prozess, vom Kreislaufbehälter fern gehalten werden. Hierdurch kann ein schnelles Verstopfen der Ultrafiltervorrichtung verhindert wird. Dies ist insbesondere bei membranbasierten Ultrafiltervorrichtungen mit Membranen aus Hohlfasern von großer Bedeutung.

Bei der Ultrafiltervorrichtung handelt es sich um eine Filtervorrichtung, welche dazu geeignet ist, dem hierin eingeleiteten und sie durchströmenden Mischabwasser Flüssigkeit zu entziehen. In der Regel handelt es sich bei dieser Flüssigkeit um Wasser, es können jedoch auch andere Flüssigkeiten oder Flüssigkeitsmischungen dem Mischabwasser entzogen werden, die möglicherweise in dem Halbleiterbearbeitungsprozess verwendet werden. Bei der Ultrafiltervorrichtung wird sichergestellt, dass Partikel, die sich in der dem Mischabwasser entzogenen Flüssigkeit befinden, Partikelgrößen von maximal etwa 0,01 µm bis etwa 0,1 µm aufweisen. Dies im Unterschied beispielsweise zu einer Mikrofiltration, bei der die entzogene Flüssigkeit Partikel in der Größenordnung von über 0,1 µm aufweisen kann. Anders ausgedrückt, wird vorliegend der Begriff "Ultra" im Ausdruck "Ultrafiltervorrichtung" dazu verwendet, die mittels der Filtervorrichtung zusammen mit der Flüssigkeit aus dem Mischwasser abgetrennte Partikelgröße zu kennzeichnen.

Beim Durchlaufen der Ultrafiltervorrichtung wird das Mischabwasser zu einem aufkonzentrierten Abwasser aufkonzentriert. Das bedeutet, dass die Slurry im aufkonzentrierten Abwasser in einer höheren Volumenkonzentration vorliegt, als in dem Mischabwasser, welches in die Ultrafiltervorrichtung eingeleitet wurde. Das Aufkonzentrieren erfolgt mittels Flüssigkeitsentzugs in der Ultrafiltervorrichtung und führt zu einer Erhöhung der Feststoffkonzentration in dem aufkonzentrierten Abwasser im Vergleich zum Mischabwasser.

Bei einer bevorzugten Ausführungsform ist vorgesehen, dass das aus dem Kreislaufbehälter entnommene Mischabwasser durch eine membranbasierte Ultrafiltervorrichtung geleitet und hierdurch mittels Entzug eines Permeats zu aufkonzentriertem Abwasser aufkonzentriert wird. Insbesondere kann es sich hierbei um eine Cross-Flow-Filtrationsvorrichtung, auch Tangential-Flow- oder Querstromfiltration genannt, handeln. Die Membran der Ultrafiltervorrichtung ist vorzugsweise aus einem Polymer hergestellt, beispielsweise aus Polyacrylnitril.

In einer vorteilhaften Weiterbildung ist vorgesehen, dass der Konzentrationsschritt unmittelbar im Anschluss an den Filtrationsschritt ausgeführt wird. Dies bedeutet, dass keine weiteren Verfahrensschritte zeitlich zwischen dem Konzentrationsschritt und dem Filtrationsschritt durchgeführt werden. Während das Mischabwasser im Filtrationsschritt aus dem Kreislaufbehälter entnommen und anschließend durch die Ultrafiltervorrichtung und zurück in den Kreislaufbehälter geleitet wird, wird die Zufuhr des frischen Abwassers in den Kreislaufbehälter, von der Steuervorrichtung gesteuert, vermindert oder vorzugsweise ganz abgestellt, um den Konzentrationsschritt einzuleiten.

Gemäß einer zweckmäßigen Ausgestaltung ist vorgesehen, dass der Konzentrationsschritt eingeleitet wird, wenn eine Feststoffkonzentration in dem Kreislaufbehälter einen vorbestimmten Niederkonzentrationsschwellwert übersteigt. Mit anderen Worten wird die Einleitung von frischem Slurry-Abwasser in den Kreislaufbehälter gestoppt, sobald der Niederkonzentrationsschwellwert erreicht ist, welcher einen Wert von zwischen etwa 1 % und 3%, vorzugsweise einen Wert von etwa 2% aufweist. Die Feststoffkonzentration wird in dem Kreislaufbehälter und / oder in einer Mischabwasser-Entnahmeleitung gemessen, beispielsweise mittels einer optischen Online-Analysiervorrichtung.

Bevorzugterweise ist vorgesehen, dass der Konzentrationsschritt eine fortlaufende Hinzugabe eines Agglomerationshemmers zu dem aus dem Kreislaufbehälter entnommenen Mischabwasser umfasst. Als Agglomerationshemmer dient vorzugsweise eine Lauge. Sie dient zur Stabilisierung der kolloidalen Slurry, um einen möglichst hohen Abstand vom sogenannten isoelektrischen Punkt (IEP) zu erhalten. Vorzugsweise wird eine Lauge verwendet, die auch in der ursprünglichen Slurry vorhanden war, also bei der Verwendung des Slurry bei der Halbleiterbearbeitung. Ein Beispiel für einen effektiven Agglomerationshemmer ist Ammoniak (NH₃).

Hierbei ist zu beachten, dass möglichst wenig Lauge ins Permeat geraten sollte, um die Kosten für die Lauge zu senken und zudem eine Verunreinigung des Permeats zu vermeiden. Das wird beim vorliegenden Wiederaufbereitungsverfahren dadurch erreicht, dass der Agglomerationshemmer nur während einer sehr kurzen Zeit zudosiert wird, nämlich im Verlauf des Konzentrationsschrittes, während dessen die Zufuhr von frischem Abwasser zu dem Kreislaufbehälter gestoppt ist. Für den Zufluss des Agglomerationshemmers verwendete Leitungen können aus Kunststoff gebildet sein und umfassen vorzugsweise Perfluoralkoxylalkan.

Bei einer zweckmäßigen Ausführungsform ist vorgesehen, dass beim Durchlauf durch die Ultrafiltervorrichtung dem Mischabwasser entzogene Flüssigkeit in einen Flüssigkeitsbehälter eingeleitet und von dort dem Halbleiterbearbeitungsprozess zugeführt wird. Vor dem Einleiten in den Flüssigkeitsbehälter und / oder vor dem Weiterleiten zum Halbleiterbearbeitungsprozess kann die Flüssigkeit weiteren Behandlungen unterzogen werden, beispielsweise weiteren Filter- oder Reinigungsschritten. Wenn eine membranbasierte Ultrafiltervorrichtung verwendet wird, kann die entzogene Flüssigkeit als Permeat und die Aufbewahrungsvorrichtung somit als Permeatbehälter bezeichnet werden.

In einer vorteilhaften Ausgestaltung ist vorgesehen, dass ein Verhältnis zwischen einer Konzentrationszeitdauer, während dessen der Konzentrationsschritt durchgeführt wird, und einer Filtrationszeitdauer, während dessen der Filtrationsschritt durchgeführt wird, kleiner als etwa 5% ist, vorzugsweise kleiner als etwa 3%. Anders ausgedrückt, verbringt die Wiederaufbereitungsvorrichtung zeitlich gesehen etwa 97% der Gesamtverfahrensdauer in einer Filtrationsphase, während dessen der Filtrationsschritt durchgeführt wird, und lediglich etwa 3% des Gesamtverfahrensdauers in einer Konzentrationsphase, während dessen der Konzentrationsschritt durchgeführt wird.

Der Konzentrationsschritt wird durchgeführt bis eine Feststoffkonzentration in dem Kreislaufbehälter einen vorbestimmten Hochkonzentrationsschwellwert übersteigt, woraufhin in einem zeitlich nachfolgenden Abfüllschritt das Mischabwasser aus dem Kreislaufbehälter als Wiederaufbereitungs-Slurry entnommen wird. Der Abfüllschritt kann hierbei weitere Filterschritte und / oder Behandlungsschritte umfassen, beispielsweise um aus der Wiederaufbereitungs-Slurry größere Partikel herauszutrennen, zum Beispiel Partikel, welche eine Partikelgröße von etwa 1µm übersteigen. Vorteilhafterweise ist vorgesehen, dass das Abwasser, das Mischabwasser, das aufkonzentrierte Abwasser, die dem Mischabwasser mittels der Ultrafiltervorrichtung entzogene Flüssigkeit und / oder die Wiederaufbereitungs-Slurry im Wesentlichen metallfrei geführt und / oder aufbewahrt werden. Mit anderen Worten, die hierfür verwendeten Leitungen und Behälter weisen metallfreie Innenoberflächen auf, die vorzugsweise vollständig aus Kunststoff gebildet sind. Vorzugsweise trifft dies für sämtliche der in der Wiederaufbereitungsvorrichtung verwendeten Leitungen, Behälter und / oder Pumpen zu. Eine metallfreie Führung und / oder Lagerung der unterschiedlichen Abwässer und Flüssigkeiten hat den Vorteil, dass keine metallischen Verunreinigungen in die Abwässer gelangen. Die Einschränkung auf eine "im Wesentlichen" metallfreie Führung oder Aufbewahrung bedeutet, dass Innenoberflächen der jeweiligen Komponenten oder die jeweiligen Komponenten im Ganzen so hergestellt sind, dass sie metallische Stoffe nur Herstellungsbedingt und nur in Spuren aufweisen.

Gemäß einer bevorzugten Ausgestaltung ist vorgesehen, dass das Mischabwasser im Kreislaufbehälter mit Inertgas überlagert wird. Anders ausgedrückt, wird in den Kreislaufbehälter oberhalb eines Mischabwasser-Füllstandes das Inertgas derart eingeleitet, dass sich dort eine Inertgas-Schicht bildet. Alternativ kann der Kreislaufbehälter oberhalb des Füllstandes mit Inertgas aufgefüllt werden. Das Inertgas ist vorzugsweise befeuchtet. Das Überlagern mit Inertgas, insbesondere mit feuchtem Inertgas, hat den Vorteil, dass eine Trocknung oder Krustenbildung des Mischabwassers an Innenwänden des Kreislaufbehälters verhindert wird. Vorzugsweise werden deshalb auch alle anderen Behälter und Tanks in der Wiederaufbereitungsvorrichtung mit feuchtem Inertgas aufgefüllt. Für den Zufluss des Inertgases verwendete Leitungen können aus Kunststoff gebildet sein und umfassen vorzugsweise Perfluoralkoxylalkan. Bei dem Inertgas kann es sich beispielsweise um Stickstoff (N₂) handeln.

Damit die unterschiedlichen Kreisläufe in der Wiederaufbereitungsvorrichtung möglichst dicht und verlustfrei sind, sollten einige oder sämtliche hier eingesetzte Pumpen zur Beförderung von Flüssigkeiten und / oder Gasen vorzugsweise lager- und dichtungslos sein. Dies gilt sowohl für Pumpen zur Beförderung des frischen Abwassers, des Abwassers, des Mischabwassers und / oder des aufkonzentrierten Abwassers, als auch für Pumpen, die zum Transport des Agglomerationshemmers sowie des Inertgases eingesetzt werden.

Bevorzugterweise sind regelmäßig eingeleitete Rückspülschritte vorgesehen, bei denen beim Durchlauf durch die Ultrafiltervorrichtung aus dem Abwasser entzogene Flüssigkeit zum Lösen von Filtermembrananlagerungen in umgekehrter Richtung durch die Ultrafiltervorrichtung geleitet wird. Derartige Filtermembrananlagerungen können als sogenannter Filterkuchen das effektive Funktionieren der Filtervorrichtung beeinträchtigen. Die Rückspülschritte können in festgelegten, äquidistanten Zeitabständen durchgeführt werden. Alternativ oder zusätzlich können Rückspülschritte durch einen gemessenen Messwert getriggert werden, der den Verschmutzungsgrad der Membran anzeigt, beispielsweise durch einen Strömungswiderstand.

Um das Verfahren kosteneffektiv zu gestalten, ist auf eine effektive Rückspülung zu achten. Insbesondere ist es von Vorteil, für die Rückspülung zusätzlich oder alternativ zur aus dem Abwasser entzogenen Flüssigkeit ein Gas zu verwenden. Vorzugsweise wird Inertgas, beispielsweise Stickstoff, oder ein Gemisch aus Inertgas und Flüssigkeit für das Rückspülen verwendet. Die Flüssigkeit, das Gas oder das Gemisch wird vorzugsweise durch die Hohlfaser gedrückt um den an der Filtermembran gebildete Filterkuchen abzuscheren. Das durch das Rückspülen entstehende Rückspülabwasser wird vorzugsweise nicht wieder dem Kreislauf zugeführt.

Die Erfindung wird im Folgenden anhand von Ausführungsbeispielen unter Bezugnahme auf die Figuren erläutert. Hierbei zeigen:
- Fig. 1: ein Diagramm einer Wiederaufbereitungsvorrichtung für Slurry-Abwasser;
- Fig. 2: die Durchführung eines Filtrationsschrittes anhand des Diagramms aus der Fig. 1;
- Fig. 3: die Durchführung eines Rückspülschrittes anhand des Diagramms aus der Fig. 1;
- Fig. 4: die Durchführung eines Konzentrationsschrittes anhand des Diagramms aus der Fig. 1;
- Fig. 5: die Durchführung eines Abfüllschrittes anhand des Diagramms aus der Fig. 1;
- Fig. 6: ein Diagramm einer Slurry-Abfüllanordnung, die der Wiederaufbereitungsvorrichtung nachgeschaltet ist.

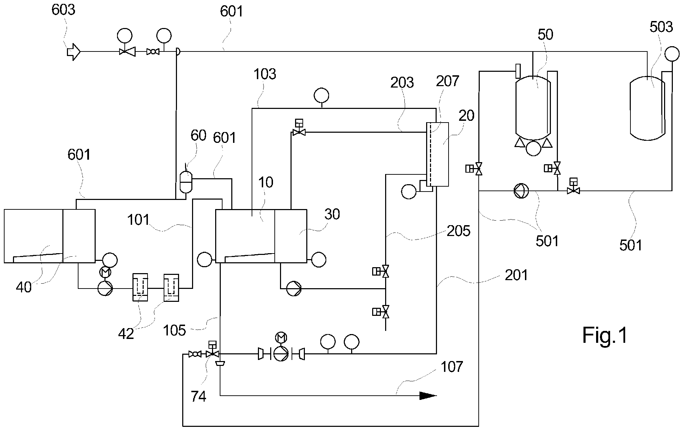

Die Fig. 1 zeigt ein Diagramm mit dem schematischen Aufbau einer Wiederaufbereitungsvorrichtung für Slurry-Abwasser. Zentrale Komponenten der Wiederaufbereitungsvorrichtung bilden ein Kreislaufbehälter 10 und eine Ultrafiltervorrichtung 20. Der Kreislaufbehälter 10 und die Ultrafiltervorrichtung 20 bilden zusammen mit einer Mischabwasser-Entnahmeleitung 105, einer Ultrafilterzuführleitung 201 und einer Abwasserrückführleitung 103 einen Kreislauf zum Aufkonzentrieren des zuvor in den Kreislaufbehälter 10 geleiteten Abwassers. Der Kreislaufbehälter 10 hat vorliegend ein Fassungsvermögen von etwa 500 Litern.

Beim Durchlauf durch die Ultrafiltervorrichtung 20 wird dem Mischabwasser Flüssigkeit entzogen, das sich in einem Flüssigkeitskreislauf umfassend einen Flüssigkeitsbehälter 30, eine Flüssigkeitsentzugsleitung 203 und eine Rückspülleitung 205 befindet, wobei Letztere jedoch nur zeitweise zum Einsatz kommt. Bei der Ultrafiltervorrichtung 20 in der vorliegenden Ausführungsform handelt es sich um einen Membranfilter mit einer Membran 207, vorzugsweise einer Polymermembran, beispielsweise aus kostengünstigem und haltbarem Polyacrylnitril. Bei der dem Mischabwasser entzogenen Flüssigkeit handelt es sich somit um ein Permeat. Der Flüssigkeitsbehälter 30 wird im Folgenden deshalb auch als Permeattank 30 bezeichnet. Der Permeattank 30 hat im vorliegenden Beispiel ein Fassungsvermögen von etwa 200 Litern.

Darüber hinaus sind in der Fig. 1 Vorlagetanks 40 dargestellt, in denen das Slurry enthaltende Abwasser aufbewahrt wird, bevor es über Vorfilter 42 entlang einer Abwasserzuführleitung 101 in den Kreislaufbehälter 10 gelangt.

Über einen N₂-Zulauf 603 wird die Wiederaufbereitungsvorrichtung mit Stickstoff versorgt, welcher mittels eines N₂-Befeuchters 60 befeuchtet und über N₂-Leitungen 501 den Vorlagetanks 40, dem Kreislaufbehälter 10 und den NH₃-Behältern 50, 503 zugeführt wird. In dem Vorlagetank 40 und dem Kreislaufbehälter 10 verhindert eine derartige feuchte N₂-Überlagerung eine Krustenbildung von trockener Slurry an Tank- beziehungsweise Behälterwänden. Andernfalls bestünde die Gefahr, dass trockene Slurry-Partikel wieder in den wiederaufbereiteten Slurry gelangen und später erhebliche Kratzer auf den im Halbleiterbearbeitungsprozess bearbeiteten Halbleitersubstraten verursachen können. Einmal getrocknete
Slurry kann nicht wieder stabilisiert werden.

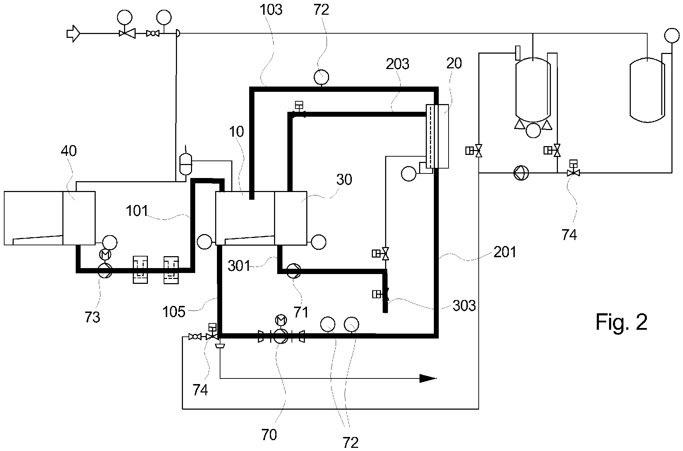

Die hier genannten und weitere Komponenten der Wiederaufbereitungsvorrichtung werden nachfolgend anhand einzelner Schritte des Wiederaufbereitungsverfahrens genauer erläutert. In den zugehörigen Fig. 2 bis Fig. 5 sind die wichtigsten aktiven, das heißt durchflossenen, Leitungen der Wiederaufbereitungsvorrichtung als breite Linien dargestellt und so gegenüber den übrigen Leitungen hervorgehoben. Im Übrigen zeigen die Fig. 2 bis 5 die gleichen Merkmale der Wiederaufbereitungsvorrichtung, wie die Fig. 1.

Fig. 2 veranschaulicht die Durchführung eines Filtrationsschrittes anhand des Diagramms aus der Fig. 1. Mittels einer Frischabwasserpumpe 73 wird in einem der Vorlagetanks 40 gespeichertes, frisches Abwasser über die Abwasserzuführleitung 101 in den Kreislaufbehälter 10 eingeleitet. Die Zufuhr frischen Abwassers erfolgt fortlaufend, während Mischabwasser mittels der Kreislaufpumpe 70 über die Mischabwasser-Entnahmeleitung 105 aus dem Kreislaufbehälter 10 heraus gepumpt und über die Ultrafilterzuführleitung 201 durch die Ultrafiltervorrichtung 20 geleitet wird. Das aus der Ultrafiltervorrichtung 20 austretende aufkonzentrierte Abwasser wird über die Abwasserrückführleitung 103 zurück in den Kreislaufbehälter 10 geleitet.

Beim Durchlaufen der Ultrafiltervorrichtung 20 wird dem Abwasser Flüssigkeit beziehungsweise Permeat entzogen, welches über die Flüssigkeitsentzugsleitung 203 in den Permeattank 30 geleitet wird. Das Permeat kann anschließend mit Hilfe einer Pumpe 71 über den Flüssigkeitsbehälter-Ausgang 301 aus dem Permeattank 30 entnommen und über die Flüssigkeitsnutzleitung 303 einem Nutzer zur Verfügung gestellt werden. Beispielsweise kann das Permeats an eine Halbleiterbearbeitungsvorrichtung zurück geleitet werden. Hierzu kann es notwendig sein, das Permeat zunächst weiteren Behandlungsschritten zu unterziehen. Vorzugsweise wird jedoch das Permeat aus der Flüssigkeitsnutzleitung 303 entnommen und ohne zusätzliche Behandlung, insbesondere ohne weitere Filterung, dem Halbleiterbearbeitungsprozess zugeführt, aus dem das frische Abwasser stammt, beispielsweise einem CMP-Prozess.

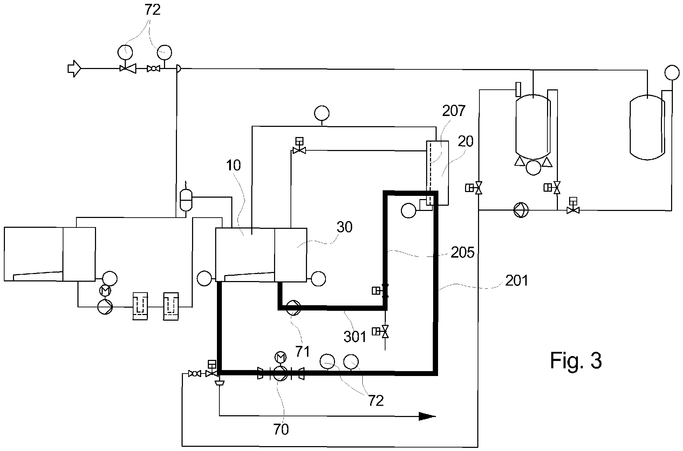

Die Filtertätigkeit in der Ultrafiltervorrichtung 20 wird von einer Membran 207 übernommen, welche für das Permeat durchlässig ist. Um zu vermeiden, dass sich auf der Membran 207 ein Filterkuchen aus den Filterablagerungen bildet, muss die Membran 207 in regelmäßigen Zeitabstand gereinigt werden. Fig. 3 veranschaulicht anhand des Diagramms aus der Fig. 1 die Durchführung eines solchen Rückspülschrittes zur Reinigung der Membran 207. Hierzu wird das mittels der Permeatpumpe 71 über den Flüssigkeitsbehälter-Ausgang 301 aus dem Permeattank 30 entnommene Permeat über die Rückspülleitung 205 in umgekehrter Richtung durch die Membran 207 gedrückt, um dort angelagerte Ablagerungen zu lösen und herauszuspülen. Das daraufhin mit den Ablagerungen verunreinigte Permeat wird über die Ultrafilterzuführleitung 201 in den Kreislaufbehälter 10 geführt.

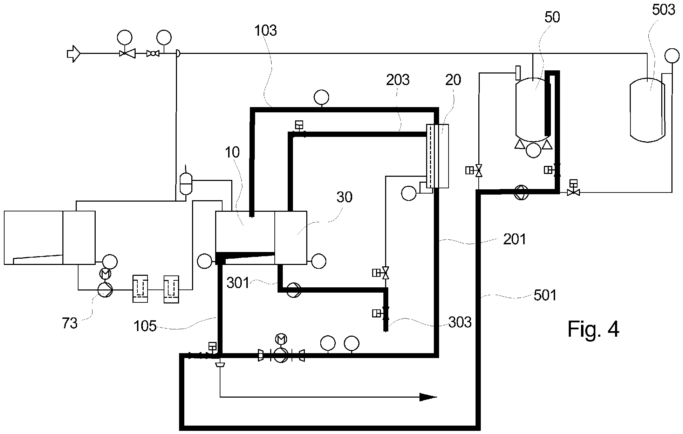

Fig. 4 veranschaulicht die Durchführung eines Konzentrationsschrittes anhand des Diagramms aus der Fig. 1. Der vorangehend in Zusammenhang mit der Fig. 2 erläuterte Kreislauf des Abwassers zwischen dem Kreislaufbehälter 10 und der Ultrafiltervorrichtung 20 wird auch während des Konzentrationsschrittes weiterhin im Wesentlichen aufrechterhalten. Es wird somit weiterhin Mischabwasser aus dem Kreislaufbehälter 10 über die Mischabwasser-Entnahmeleitung 105 entnommen und über die Ultrafilterzuführleitung 201 durch die Ultrafiltervorrichtung 20 geleitet. Von dort wird aufkonzentriertes Abwasser über die Abwasserrückführleitung 103 in den Kreislaufbehälter 10 geleitet. Das dem Mischabwasser in der Ultrafiltervorrichtung 20 entzogene Permeat wird über die Flüssigkeitsentzugsleitung 203 in den Permeattank 30 geleitet, und von dort über den Flüssigkeitsbehälter-Ausgang 301 und die Flüssigkeitsnutzleitung 303 für die weitere Nutzung bereitgestellt.

Im Unterschied zum Filtrationsschritt wird jedoch kein frisches Abwasser in den Kreislaufbehälter 10 geleitet. Die Frischabwasserpumpe 73 bleibt in dieser Phase des Wiederaufbereitungsverfahrens somit inaktiv. Stattdessen wird jedoch dem Mischabwasser in der Mischabwasser-Entnahmeleitung 105 Ammoniak (NH₃) aus dem NH₃-Behälter 50 über einem der NH₃-Leitungen 601 hinzugefügt. Wenn der NH₃-Behälter 50 aufgebraucht ist, sorgt ein NH₃-Vorratsbehälter 503 für die Versorgung mit NH₃. Ammoniak wirkt als Agglomerationshemmer und verhindert ein Verklumpen der Feststoffe in dem Mischabwasser, dessen Feststoffkonzentration im Konzentrationsschritt aufgrund des Ausbleibens des frischen Slurry-Abwassers schnell ansteigt.

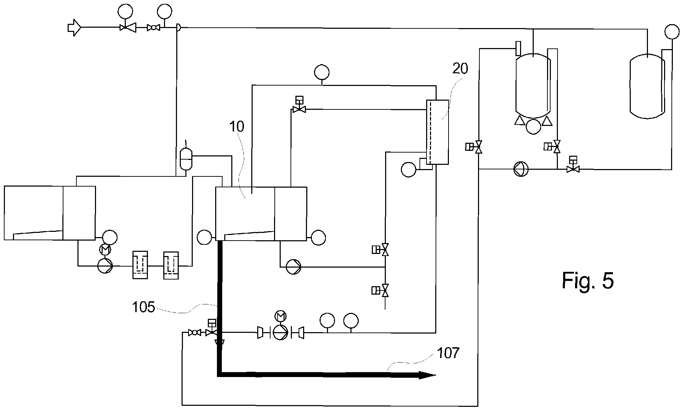

Fig. 5 veranschaulicht die Durchführung eines Abfüllschrittes, ebenfalls anhand des Diagramms aus der Fig. 2. Dieser Schritt wird eingeleitet, nachdem das Mischabwasser in dem Kreislaufbehälter 10 mittels des Konzentrationsschrittes derart aufkonzentriert wurde, dass seine Feststoffkonzentration einen vorbestimmten Hochkonzentrationsschwellwert übersteigt. Die Wiederaufbereitungsvorrichtung wird mittels einer Mehrzahl an Messgeräten 72 überwacht, welche Durchflusssensoren, Temperatursensoren, Konzentrationssensoren, Feuchtigkeitssensoren und dergleichen umfassen können. Die Feststoffkonzentration wird anhand von Konzentrationsmessern ermittelt und in der Steuervorrichtung (in den Figuren nicht dargestellt) mit dem Hochkonzentrationsschwellwert verglichen.

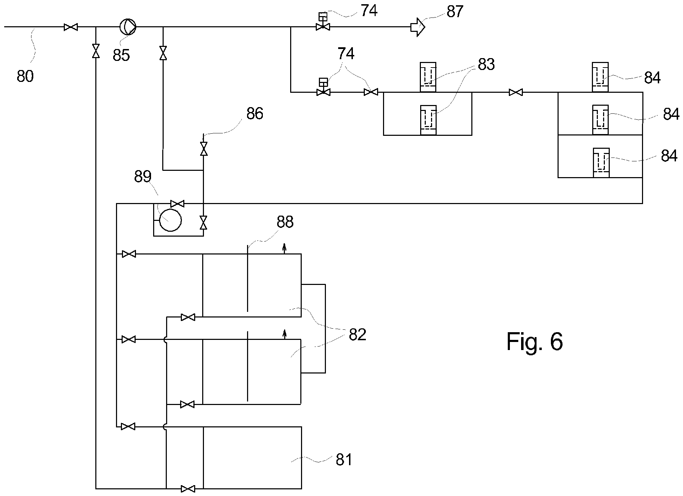

Im Diagramm der Fig. 6 ist eine Slurry-Abfüllanordnung schematisch dargestellt. Sie dient dazu, die wiederaufbereitete Slurry, welche in dem in Fig. 5 dargestellten Abfüllschritt über die Abfüllleitung 107 aus dem Kreislaufbehälter 10 herausgenommen wird, in dafür vorgesehene Wiederaufbereitungsslurry-Behälter 82 zu füllen. Gegebenenfalls wird der wiederaufbereitete Slurry zuvor einer Nachbehandlung unterworfen, wie beispielsweise einer Filterung über eine oder mehrere Filterstufen. Im vorliegenden Fall umfasst die in der Fig. 6 gezeigte Abfüllanordnung Filter 83 einer ersten Filterstufe zur Entfernung von Partikeln mit einer Partikelgröße von mindestens 2µm sowie Filter 84 einer zweiten Filterstufe zur Entfernung von Partikeln mit einer Partikelgröße von mindestens 0,5µm.

Mit Hilfe von Ventilen 74 wird die wiederaufbereitete Slurry nach dem Durchlaufen der Filter 83, 84 in die Wiederaufbereitungsslurry-Behälter 82 gefüllt. Es besteht auch die Möglichkeit, bei entsprechender Ansteuerung einer Konzentratpumpe 85 und der Ventile 74, die wiederaufbereitete Slurry über einen Ausgang 87 zu einer Konzentrat-Abwasserbehandlung weiterzuleiten. Indem die Ventile 74 entsprechend angesteuert werden, kann ferner die Partikelgröße der Partikel in der abgefüllten Slurry geregelt werden, ebenso gegebenenfalls ihre Partikeldichte und Zusammensetzung. Diese Parameter werden mittels einer Online-Analysiervorrichtung 89 kontrolliert und überwacht.

Die in der Fig. 6 dargestellte Slurry-Abfüllanordnung weist ferner einen Frischslurry-Behälter 81 und einen Eingang 86 für entionisiertes Wasser auf. Mit frischem Slurry und / oder entionisiertem Wasser sowie gegebenenfalls mithilfe weiterer Chemikalien kann die wiederaufbereitete Slurry zur weiteren Verwendung optimal konditioniert werden. Schließlich weisen die Wiederaufbereitungsslurry-Behälter 82 jeweils eine Stickstoffzuleitung 88 auf, um die Behälter 82 mit vorzugsweise feuchtem Stickstoff aufzufüllen.

### Bezugszeichenliste:

10 Kreislaufbehälter
   101 Abwasserzuführleitung
   103 Abwasserrückführleitung
   105 Mischabwasser-Entnahmeleitung
   107 Abfüllleitung
20 Ultrafiltervorrichtung
   201 Ultrafilterzuführleitung
   203 Flüssigkeitsentzugsleitung
   205 Rückspülleitung
   207 Membran
30 Flüssigkeitsbehälter (Permeattank)
   301 Flüssigkeitsbehälter-Ausgang
   303 Flüssigkeitsnutzleitung
40 Vorlagetanks
   42 Vorfilter
50 NH₃-Behälter
   501 NH₃-Leitung
   503 NH₃-Vorratsbehälter
60 N₂-Befeuchter
   601 N₂-Leitungen
   603 N₂-Zulauf
70 Kreislaufpumpe
   71 Permeatpumpe
   72 Messgeräte
   73 Frischabwasserpumpe
   74 Ventile
81 Frischslurry-Behälter
   82 Wiederaufbereitungsslurry-Behälter
   83 Filter erster Filterstufe
   84 Filter zweiter Filterstufe
   85 Konzentratpumpe
   86 Eingang für entionisiertes Wasser
   87 Ausgang zur Konzentrat-Abwasserbehandlung
   88 Stickstoffzuleitung
   89 Online-Analysiervorrichtung

## Patentansprüche

1. Wiederaufbereitungsverfahren für Slurry-Abwasser aus einem Halbleiterbearbeitungsprozess, insbesondere aus einem chemischmechanischen Polierprozess, umfassend die folgenden Verfahrensschritte:
- ein Filtcationsschritt, bei dem fortlaufend frisches Slurry enthaltendes Abwasser einem Kreislaufbehälter (10) zugeführt wird, während fortlaufend Mischabwasser aus dem Kreislaufbehälter (10) entnommen, das entnommene Mischabwasser durch eine Ultrafiltetvorrichtung (20) geleitet und hierdurch mittels Flüssigkeitsentzug zu aufkonzentriertem Abwasser aufkonzentriert und das aufkonzentrierte Abwasser in den Kreislaufbehälter (10) geleitet wird und sich mit dem Inhalt des Kreislaufbehälters (10) vermischt, um das Mischabwasser zu erhalten; und
- ein dem Filtrationsschritt zeitlich nachfolgender Konzentrationsschritt, bei dem die Zufuhr des frischen Abwassers zum Kreislaufbehälter (10) vermindert oder abgestellt ist, während fortlaufend Mischabwasser aus dem Kreislaufbehälter (10) entnommen, das entnommene Mischabwasser durch die Ultrafiltervorrichtung (20) geleitet und hierdurch mittels Flüssigkeitsentzug zu aufkonzentriertem Abwasser auf konzentriert und das auf konzentrierte Abwasser in den Kreislaufbehälter (10) geleitet wird bis eine Feststoffkonzentration in dem Kreislaufbehälter einen vorbestimmten Hochkonzentrationsschwellwert übersteigt, woraufhin in einem zeitlich nachfolgenden Abfüllschritt das Mischabwasser aus dem Kreislaufbehälter als Wiederaufbereitungs-Slurry entnommen wird,
und wobei ein Agglomerationshemmer nur im Verlauf des Konzentrationsschrittes zudosiert wird.

2. Wiederaufbereitungsverfahren nach Anspruch 1, **dadurch gekennzeichnet,**
**dass** das aus dem Kreislaufbehälter (10) entnommene Mischabwasser
durch eine Ultrafiltervorrichtung geleitet und hierdurch
mittels Entzug eines Permeats zu aufkonzentriertem Abwasser
aufkonzentriert wird, wobei die Ultrafiltriervorrichtung eine Membran aufweist, welche für das Permeat durchlässig ist.

3. Wiederaufbereitungsverfahren nach Anspruch 1 oder 2, **dadurch**
**gekennzeichnet, dass** der Konzentrationsschritt unmittelbar im Anschluss an den Filtrationsschritt ausgeführt wird.

4. Wiederaufbereitungsverfahren nach einem der vorangehenden Ansprüche, **dadurch gekennzeichnet, dass** der Konzentrationsschritt eingeleitet wird, wenn eine Feststoffkonzentration in dem Kreislaufbehälter (10) einen vorbestimmten Niederkonzentrationsschwellwert übersteigt.

5. Wiederaufbereitungsverfahren nach einem der vorangehenden Ansprüche, **dadurch gekennzeichnet, dass** der Konzentrationsschritt eine fortlaufende Hinzugabe eines Agglomerationshemmers zu dem aus dem Kreislaufbehälter (10) entnommenen Mischabwasser umfasst.

6. Wiederaufbereitungsverfahren nach einem der vorangehenden Ansprüche, **dadurch gekennzeichnet, dass** beim Durchlauf durch die Ultrafiltervorrichtung dem Mischabwasser entzogene Flüssigkeit in einen Flüssigkeitsbehälter eingeleitet und von dort dem Halbleiterbearbeitungsprozess zugeführt wird.

7. Wiederaufbereitungsverfahren nach einem der vorangehenden Ansprüche, **dadurch gekennzeichnet, dass** ein Verhältnis zwischen einer Konzentrationszeitdauer, während dessen der Konzentrationsschritt durchgeführt wird, und einer Filtrationszeitdauer, während dessen der Filtrationsschritt durchgeführt wird, kleiner als 5% ist.

8. Wiederaufbereitungsverfahren nach einem der vorangehenden Ansprüche, **dadurch gekennzeichnet, dass** das Abwasser, das Mischabwasser, das aufkonzentrierte Abwasser, die dem Mischabwasser mittels der Ultrafiltervorrichtung entzogene Flüssigkeit und / oder die
Wiederaufbereitungs-Slurry so geführt und / oder
aufbewahrt werden, dass die Innenoberflächen der hierfür verwendeten Leitungen,
Behälter und / oder Pumpen metallische Stoffe nicht oder herstellungsbedingt nur in Spuren aufweisen.

9. Wiederaufbereitungsverfahren nach einem der vorangehenden Ansprüche,
**dadurch gekennzeichnet, dass** das Mischabwasser im Kreislaufbehälter (10) mit Inertgas überlagert wird.

10. Wiederaufbereitungsverfahren nach einem der vorangehenden Ansprüche,
**gekennzeichnet durch** in festgelegten, äquidistanten Zeitabständen durchgeführte und/oder **durch** einen gemessenen Messwert, der den Verschmutzungsgrad der Membran anzeigt, getriggerte Rückspülschritte, bei
denen beim Durchlauf **durch** die Ultrafiltervorrichtung aus dem Abwasser entzogene Flüssigkeit zum Lösen von Filtermembrananlagerungen in
umgekehrter Richtung **durch** die Ultrafiltervorrichtung geleitet wird.

11. Wiederaufbereitungsvorrichtung zur Wiederaufbereitung von Slurry-Abwasser aus einem Halbleiterbearbeitungsprozess, insbesondere aus
einem chemisch-mechanischen Polierprozess, umfassend:
- einen Kreislaufbehälter (10) zum Aufnehmen Slurry enthaltendes Abwassers;
- eine mit dem Kreislaufbehälter (10) verbundene Abwasserzuführleitung (101);
- eine über eine Ultrafilterzuführleitung (201) mit dem Kreislaufbehälter (10) verbundene Ultrafiltervorrichtung zum Aufkonzentrieren fortlaufend aus dem Kreislaufbehälter (10) entnommenen Mischabwassers mittels Flüssigkeitsentzug;
- eine Abwasserrückführleitung (105) zum Leiten des auf konzentrierten Abwasser in den Kreislaufbehälter (10); und
- eine Steuerungsvorrichtung, welche ausgebildet ist, zeitlich nacheinander einen Filtrationsschritt, bei dem während einer fortlaufenden Entnahme von Mischabwasser aus dem Kreislaufbehälter (10) und seiner Aufkonzentrierung mittels der Ultrafiltervorrichtung dem Kreislaufbehälters (10) fortlaufend frisches Abwasser zugeführt wird, und einen Konzentrationsschritt durchzuführen, bei dem während der fortlaufenden Entnahme von Mischabwasser aus dem Kreislaufbehälter (10) und seiner Aufkonzentrierung mittels der Ultrafiltervorrichtung die Zufuhr des frischen Abwassers zum Kreislaufbehälter (10) vermindert oder abgestellt ist bis eine Feststoffkonzentration in dem Kreislaufbehälter einen vorbestimmten Hochkonzentrationsschwellwert übersteigt, woraufhin in einem zeitlich nachfolgenden Abfüllschritt das Mischabwasser aus dem Kreislaufbehälter als Wiederaufbereitungs-Slurry entnommen wird,
und wobei ein Agglomerationshemmer nur im Verlauf des Konzentrationsschrittes zudosiert wird.

## Claims

1. A recycling method for waste water containing slurry from a semi-conductor treatment process, in particular from a chemico-mechanical polishing process, comprising the following method steps:
- a filtration step in which fresh waste water containing slurry is continuously passed to a circulation container (10), while mixed waste water is continuously extracted from the circulation container (10), the extracted mixed water is passed through an ultrafiltration device (20) and thereby concentrated to produce concentrated waste water by means of withdrawal of liquid, and the concentrated waste water is passed into the circulation container (10) and mixes with the content of the circulation container (10), in order to obtain the mixed waste water;
and
- a concentration step that follows the filtration step, in terms of time, in which the supply of fresh waste water to the circulation container (10) is reduced or shut off, while mixed waste water is continuously extracted from the circulation container (10), the extracted mixed water is passed through the ultrafiltration device (20) and thereby concentrated to produce concentrated waste water by means of withdrawal of liquid, and the concentrated waste water is passed into the circulation container (10) until a solids concentration in the circulation container reaches a predetermined high concentration threshold, whereupon the mixed waste water is extracted from the circulation container as recycling slurry, in a filling step that follows, in terms of time,
and wherein an agglomeration inhibitor is metered in only during the course of the concentration step.

2. The recycling step according to claim 1, **characterized in that** the mixed waste water extracted from the circulation container (10) is passed through an ultrafiltration device and thereby concentrated to produce concentrated waste water by means of withdrawal of a permeate, wherein the ultrafiltration device has a membrane that is permeable for the permeate.

3. The recycling step according to claim 1 or 2, **characterized in that** the concentration step is carried out directly following the filtration step.

4. The recycling step according to one of the preceding claims, **characterized in that** the concentration step is initiated when a solids concentration in the circulation container (10) exceeds a predetermined low concentration threshold.

5. The recycling step according to one of the preceding claims, **characterized in that** the concentration step comprises continuous addition of an agglomeration inhibitor to the mixed waste water extracted from the circulation container (10).

6. The recycling step according to one of the preceding claims, **characterized in that** as the mixed waste water passes through the ultrafiltration device, liquid extracted from the mixed waste water is introduced into a container for liquid and from there passed to the semi-conductor treatment process.

7. The recycling step according to one of the preceding claims, **characterized in that** a relation between the concentration time period during which the concentration step is carried out and a filtration time period during which the filtration step is carried out is less than 5 %.

8. The recycling step according to one of the preceding claims, **characterized in that** the waste water, the mixed waste water, the concentrated waste water, the liquid withdrawn from the mixed waste water by means of the ultrafiltration device and/or the recycling slurry are conducted and/or stored in such a manner that the inner surfaces of the lines, containers and/or pumps used for this purpose demonstrate no metallic substances or demonstrate only production-related traces of them.

9. The recycling step according to one of the preceding claims, **characterized in that** the mixed waste water has inert gas superimposed on it in the circulation container (10).

10. The recycling step according to one of the preceding claims, **characterized by** back-flush steps that are carried out in predetermined, equidistant time intervals and/or triggered by a measured measurement value that indicates the degree of contamination of the membrane, during which steps liquid withdrawn from the waste water as it passes through the ultrafiltration device is passed through the ultrafiltration device in the reverse direction, in order to loosen filter membrane deposits.

11. A recycling device for recycling of waste water containing slurry from a semi-conductor treatment process, particularly from a chemico-mechanical polishing process, comprising:
- a circulation container (10) for accommodating waste water containing slurry;
- a waste water feed line (101) connected with the circulation container (10);
- an ultrafiltration device connected with the circulation container (10) by way of an ultrafiltration feed line (201), for concentrating mixed waste water continuously extracted from the circulation container (10) by means of withdrawal of liquid;
- a waste water return line (105) for passing the concentrated waste water into the circulation container (10); and
- a control device that is configured for carrying out, one after the other, in terms of time, a filtration step in which fresh waste water is continuously fed into the circulation container (10) during continuous extraction of mixed waste water from the circulation container (10) and its concentration by means of the ultrafiltration device, and a concentration step in which the feed of fresh waste water to the circulation container (10) is reduced or shut off until a solids concentration in the circulation container exceeds a predetermined high concentration value, whereupon the mixed waste water is extracted from the circulation container again during a filling step that follows, in terms of time,
and wherein an agglomeration inhibitor is metered in only during the course of the concentration step.

## Revendications

1. Procédé de retraitement d'eaux usées contenant de la boue provenant d'un processus de traitement de semi-conducteurs, en particulier provenant d'un processus de polissage chimico-mécanique, comprenant les étapes de procédé suivantes :
- une étape de filtration, dans laquelle des eaux usées brutes contenant de la boue sont amenées en continu à un récipient à circulation (10), pendant que des eaux usées mélangées sont prélevées en continu du récipient à circulation (10), les eaux usées mélangées prélevées sont menées à travers un dispositif d'ultrafiltration (20) et, par ce biais, sont concentrées en eaux usées concentrées au moyen d'un prélèvement de liquide et les eaux usées concentrées sont menées dans le récipient à circulation (10) et sont mélangées avec le contenu du récipient à circulation (10) afin d'obtenir les eaux usées mélangées ; et
- et une étape de concentration, suivant dans le temps l'étape de filtration, dans laquelle l'alimentation en eaux usées brutes vers le récipient à circulation (10) est diminuée ou arrêtée, pendant que des eaux usées mélangées sont prélevées en continu du récipient à circulation (10), les eaux usées mélangées prélevées sont passées par le dispositif d'ultrafiltration (20) et sont concentrées par ce biais en eaux usées concentrées au moyen d'un retrait de liquide et les eaux usées concentrées sont menées dans le récipient à circulation (10) jusqu'à ce qu'une concentration en matières solides dans le récipient à circulation dépasse une valeur de seuil de concentration supérieure prédéterminée, à la suite de quoi les eaux usées mélangées sont prélevées sous la forme de boue de traitement dans une étape de vidange à partir du récipient à circulation, suivant dans le temps,
et où un inhibiteur d'agglomération est ajouté sous forme d'une dose uniquement au cours de l'étape de concentration.

2. Procédé de retraitement selon la revendication 1, **caractérisé en ce que** les eaux usées mélangées prélevées à partir du récipient à circulation (10) sont menées à travers un dispositif d'ultrafiltration et sont concentrées par ce biais en eaux usées concentrées au moyen d'un prélèvement de perméat, où le dispositif d'ultrafiltration présente une membrane, laquelle est perméable au perméat.

3. Procédé de retraitement selon la revendication 1 ou 2, caractérisé en ce l'étape de concentration est effectuée immédiatement à la suite de l'étape de filtration.

4. Procédé de retraitement selon l'une des revendications précédentes, **caractérisé en ce que** l'étape de concentration est mise en route lorsque la concentration en matière solide dans le récipient à circulation (10) dépasse une valeur de seuil de concentration inférieure prédéfinie.

5. Procédé de retraitement selon l'une des revendications précédentes, **caractérisé en ce que** l'étape de concentration comprend un ajout en continu d'un inhibiteur d'agglomération aux eaux usées mélangées prélevées à partir du récipient à circulation (10).

6. Procédé de retraitement selon l'une des revendications précédentes, **caractérisé en ce que**, lors du déroulement, du liquide prélevé des eaux usées mélangées par le dispositif d'ultrafiltration est introduit dans un récipient pour liquides et est alimenté à partir de là vers le processus de traitement de semi-conducteurs.

7. Procédé de retraitement selon l'une des revendications précédentes, **caractérisé en ce qu'**un rapport entre une durée de concentration, pendant laquelle l'étape de concentration est effectuée, et une durée de filtration, pendant laquelle l'étape de filtration est effectuée, est inférieur à 5 %.

8. Procédé de retraitement selon l'une des revendications précédentes, **caractérisé en ce que** les eaux usées, les eaux usées mélangées, les eaux usées concentrées, le liquide prélevé des eaux usées mélangées au moyen du dispositif d'ultrafiltration, et/ou la boue de retraitement sont menés, et/ou sont conservés de telle manière que les surfaces intérieures des conduites, des récipients et/ou des pompes employés à cette fin ne présentent pas de matières métalliques ou uniquement des traces liées à leur fabrication.

9. Procédé de retraitement selon l'une des revendications précédentes, **caractérisé en ce que** les eaux usées mélangées sont conditionnées dans le récipient à circulation (10) sous un gaz inerte.

10. Procédé de retraitement selon l'une des revendications précédentes, **caractérisé par** des étapes de lavage à contre-courant déclenchées, exécutées à des intervalles de temps fixes, équidistants, et/ou par une valeur de mesure qui indique le degré de salissure de la membrane, dans lesquelles
lors du déroulement, du liquide prélevé à partir des eaux usées par le dispositif d'ultrafiltration est mené à contre-courant pour la dissolution de dépôts sur les membranes de filtres par le dispositif d'ultrafiltration.

11. Dispositif de retraitement pour le retraitement d'eaux usées contenant de la boue provenant d'un processus de traitement de semi-conducteurs, en particulier d'un processus de polissage chimico-mécanique, comprenant :
- un récipient à circulation (10) pour la réception d'eaux usées contenant de la boue ;
- une conduite d'alimentation (101) en eaux usées reliée avec le récipient à circulation (10) ;
- un dispositif d'ultrafiltration relié avec le récipient à circulation (10) par l'intermédiaire d'une conduite d'alimentation d'ultrafiltration (201) pour la concentration en continu des eaux usées mélangées prélevées à partir du récipient à circulation (10) au moyen d'un retrait de liquide ;
- une conduite d'alimentation à contre-courant d'eaux usées (105) pour la conduite des eaux usées concentrées dans le récipient à circulation (10) ; et
- un dispositif de commande, lequel est conçu pour exécuter, dans le temps, l'une après l'autre, une étape de filtration, dans laquelle, pendant un prélèvement en continu d'eaux usées mélangées à partir d'un récipient à circulation (10) et sa concentration au moyen d'un dispositif d'ultrafiltration, des eaux usées brutes sont amenées en continu vers le récipient à circulation (10), et une étape de concentration, dans laquelle, pendant le prélèvement en continu d'eaux usées mélangées à partir du récipient à circulation (10) et de sa concentration au moyen du dispositif d'ultrafiltration, l'ajout des eaux usées brutes au récipient à circulation (10) est diminué ou arrêté jusqu'à ce qu'une concentration en matières solides dépasse une valeur de seuil de concentration supérieure prédéfinie dans le récipient à circulation, à la suite de quoi, les eaux usées mélangées sont prélevées à partir du récipient à circulation sous la forme de boue de traitement dans une étape de vidange, suivant dans le temps,
et où un inhibiteur d'agglomération est ajouté sous forme de dose uniquement lors du déroulement de l'étape de concentration.
